# EUROPEAN PATENT APPLICATION

(11) **EP 1 353 226 A2**
(43) Date of publication of application: **15.10.2003**
(21) Application number: 03252300.3
(22) Date of filing: 11.04.2003
(51) Int. Cl.: G03F 7/09

(54) **Method for manufacturing resist pattern**

(30) Priority: 12.04.2002 JP 2002111383
(71) Applicant: DAI NIPPON PRINTING CO., LTD., Tokyo 162-8001 (JP)
(72) Inventor: Sasaki, Shiho, c/o Dai Nippon Printing Co., Ltd., Tokyo-to, 162-8001 (JP); Kurihara, Masaaki, Dai Nippon Printing Co., Ltd., Tokyo-to, 162-8001 (JP); Fujii, Akiko, c/o Dai Nippon Printing Co., Ltd., Tokyo-to, 162-8001 (JP)
(74) Representative: Geary, Stephen

(57) **Abstract**

The main object of the present invention is to provide a method for manufacturing a high precision resist pattern upon use of a chemical amplification-type resist and a conductive film. The present invention attains the above object by providing a method for manufacturing a resist pattern comprising:
an irradiating process of irradiating a substrate having, a chemical amplification-type resist layer on one surface of a base, and a conductive film which is formed on the chemical amplification-type resist layer and releases an acid by heating, with an electron beam in a pattern manner from the conductive film side,
a conductive film removing process of removing the conductive film from the substrate which is irradiated with an electron beam,
a post-exposure baking process of subjecting the substrate, from which the conductive film is removed, to post-exposure baking, and
a developing process of performing development on the substrate which is subjected to post-exposure baking, to form a pattern comprising the chemical amplification-type resist.

## Description

The present invention relates to a method for manufacturing a high precision resist pattern upon manufacture of high density integrated circuits such as LSI, super-LIS and the like, photomasks and the like.

Semiconductor integrated circuits such as IC, LSI, super-LSI and the like are manufactured by coating a resist on a substrate to be processed such as silicon wafer and the like, exposing the resist with a desired pattern using a stepper or the like, and repeating lithography processes such as development, etching and the like.

There is a tendency that such the resist used in lithography processes are required to be highly precise, accompanied with enhanced performance and high integration of semiconductor integrated circuits.

Recently, as a resist material for forming such a fine pattern, a chemical amplification-type resist comprising components of an acid generator, a base resin, a cross-linking agent (negative type) and a dissolution suppressing agent (positive type) is used. In this resist, an acid is generated from an acid generator by irradiation with an electron beam, this resist in which an acid is generated is heated, whereby, an acid acts as a catalyst for a cross-linking reaction between a cross-linking agent and a resin in the case of a negative-type, and an acid acts as a catalyst for a chemical reaction at a part which suppresses dissolution of a resin in the case of a positive-type. Thus, this resist is known as a resist having the high sensitivity to irradiation with an electron beam. In addition, this is also known to be excellent in resolution and resistance to dry etching.

Here, in formation of a pattern by electron beam irradiation, it is necessary to ground from a substrate at irradiation with an electron beam. When this grounding is insufficient, since an entire substrate is electrified, a position of an electron injected later is deviated, and formation of a high precision pattern is inhibited. Conventionally, in manufacture of a resist pattern, there is adopted a method of inserting a needle into a resist from an upper side at irradiation with an electron beam, and ground from a conductive metal film or the like formed beneath a resist. However, this method has a problem such that a position of a needle must be adjusted or examined to ground assuredly. In addition, at manufacture of a phase shift mask and the like, since a conductive layer of a metal film or the like is formed not on an entire surface but in a dotted manner, it is difficult to ground an entire substrate from a conductive layer, leading to partial electrification in some cases.

Then, in such the case, there is used a method of coating a resist on a substrate, thereafter forming a conductive film on the resist, and ground from the conductive film on the surface. For this conductive film, water-soluble type and organic solvent-soluble type conductive polymers are used.

However, there is a problem as follows: since this conductive polymer is acidic, it promotes a catalytic reaction of an acid in a chemical amplification-type resist in manufacture of a resist pattern by chemical amplification-type and, therefore, when a chemical amplification-type resist is heated, this conductive film works as with an acid in a resist, the surface of a resist is reacted, causing reduction in resolution.

Accordingly, a provision of a method for manufacturing a high precision resist pattern upon use of a chemical amplification-type resist and a conductive film has been desired.

The first aspect of the present invention provides a method for manufacturing a resist pattern comprising:
an irradiating process of irradiating a substrate having, a chemical amplification-type resist layer on one surface of a base, and a conductive film which is formed on the chemical amplification-type resist layer and releases an acid by heating, with an electron beam in a pattern manner from the conductive film side,
a conductive film removing process of removing the conductive film from the substrate which is irradiated with an electron beam,
a post-exposure baking process of subjecting the substrate, from which the conductive film is removed, to post-exposure baking, and
a developing process of performing development on the substrate which is subjected to post-exposure baking, to form a pattern having the chemical amplification-type resist.

According to the present invention, since the conductive film removing process of removing the conductive film is performed before the above-mentioned post-exposure baking process, it becomes possible to prevent the conductive film from working as an acid as with acid in the chemical amplification-type resist in a post-exposure baking process, and it becomes possible to form a high precision pattern.

In the present invention, the conductive film is preferred to be water-soluble. Since the conductive film is water-soluble, the conductive film can be removed by water in the conductive film removing process. Therefore, treatment is simple, and also preferable in the aspect of the manufacturing efficiency and the cost.

The second aspect of the present invention provides a photomask, which is obtainable by and is preferably manufactured by the method for manufacturing a resist pattern according to the first aspect of the invention.

According to the second aspect, by manufacturing a photomask by the method for manufacturing a resist pattern according to the first aspect of the invention, a photomask having a high precision pattern becomes possible.

According to the present invention, since the above-mentioned conductive film removing process of removing the conductive film is performed before the above-mentioned post-exposure baking process, it becomes possible to prevent the conductive film from working as an acid generator by heating at a post-exposure baking process, and it becomes possible to form a high precision pattern.

FIGS. 1A, 1B, 1C, and 1D are process views showing one example of a method for manufacturing a resist pattern of the present invention.

FIG. 2 is a schematic cross-sectional view showing one example of a resist pattern of the present invention.

The present invention relates to a method for manufacturing a resist pattern and a photomask. These will be explained separately below.

### 1. Method for manufacturing resist pattern

A method for manufacturing a resist pattern of the present invention comprises:
an irradiating process of irradiating a substrate having, a chemical amplification-type resist layer on one surface of a base, and a conductive film which is formed on the chemical amplification-type resist layer and releases an acid by heating, with an electron beam in a pattern manner from the conductive film side,
a conductive film removing process of removing the conductive film from the substrate which is irradiated with an electron beam,
a post-exposure baking process of subjecting the substrate, from which the conductive film is removed, to post-exposure baking, and
a developing process of performing development on the substrate which is subjected to post-exposure baking, to form a pattern having the chemical amplification-type resist.

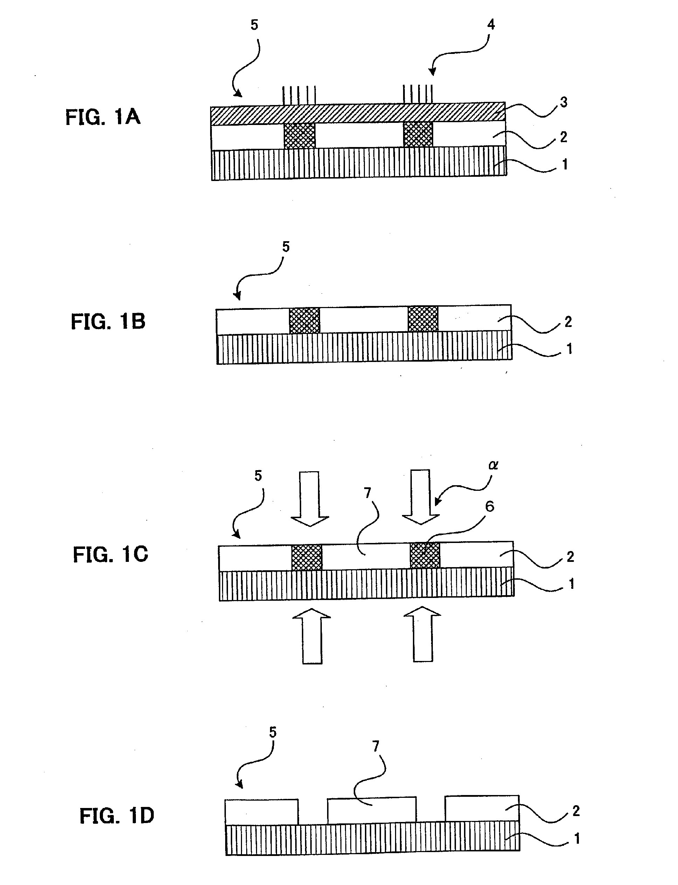

FIGS. 1A, 1B, 1C, and 1D show one example of a method for manufacturing a resist pattern. FIGS. 1A, 1B, 1C, and 1D will be specifically explained below.

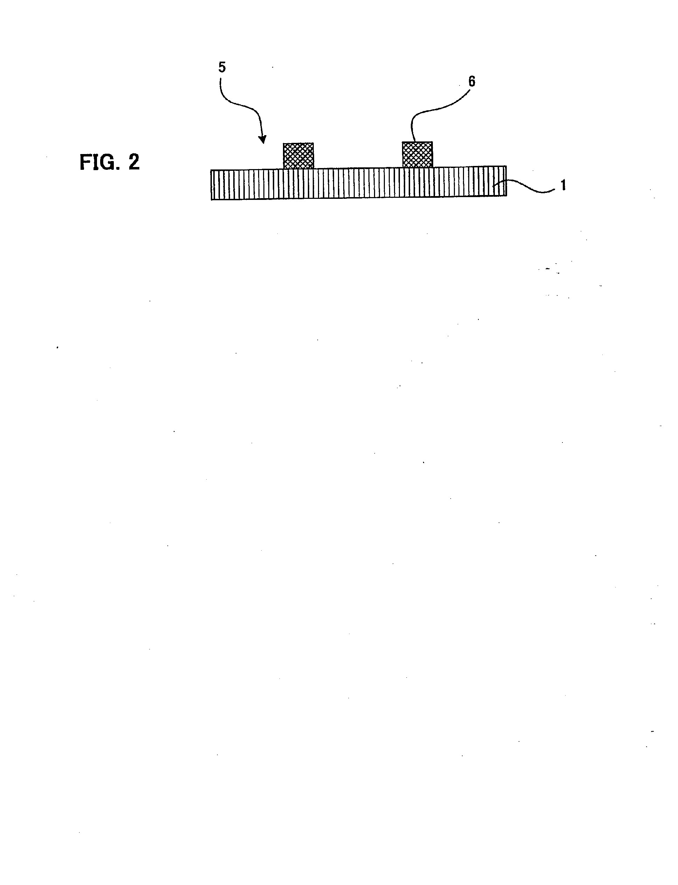

First, as shown in FIG. 1A, a substrate 5 in which a chemical amplification-type resist layer 2 is formed on one surface of a base 1 and a conductive film 3 is formed on the chemical amplification-type resist layer 2 is irradiated with an electron beam 4 in a desired pattern from the conductive film 3 side (irradiating process). Then, as shown in FIG. 1B, the conductive film 3 is removed from the substrate 5 which is irradiated with an electron beam (conductive film removing process). Then, as shown in FIG. 1C, the substrate 5 obtained from the above-mentioned process is subjected to post-exposure baking by heating using heat α, a catalytic reaction of an acid generated in an electron beam-irradiated section 6 is promoted, to make the electron beam-irradiated section 6 soluble or insoluble in a developer (post-exposure baking process). Here, when the chemical amplification-type resist is a positive type resist, the electron beam-irradiated section 6 becomes soluble in the developer in the developing process, and an electron beam-non-irradiated section 7 is formed as a pattern (FIG. 1D). On the other hand, when the chemical amplification-type resist is a negative type resist, an electron beam-irradiated section 6 becomes insoluble in the developer in the developing process, and the section is formed as a pattern (FIG. 2). These processes will be explained separately below.

### A. Irradiating process

An irradiating process of the present invention is a process of irradiating a substrate in which a chemical amplification-type resist layer is formed on one surface of a base and a conductive film releasing an acid by heating is formed on the chemical amplification-type resist layer, with an electron beam in a pattern manner from the conductive film side.

First, the conductive film used in the present invention will be explained.

By forming the above-mentioned conductive film on the surface of the substrate at electron beam irradiation, it becomes possible to ground from the conductive film on the surface also in a substrate in which the conductive layer such as a metal layer and the like is formed beneath a resist layer. So that processes such as adjustment and examination of a position of a needle upon ground connection become easy, being advantageous from a viewpoint of the manufacturing efficiency and the cost. In addition, it becomes possible to ground a substrate which can not be grounded from a metal layer, by forming the above-mentioned conductive film on the surface of the substrate in manufacturing or the like of a phase shift mask.

Further, since the above-mentioned conductive film is formed on the surface, it becomes possible to remove the conductive film by the conductive film treating process described below, and it becomes possible to form a fine pattern.

The conductive film used in the present invention generates an acid by heating, and is not particularly limited as far as it is a conductive polymer which is water-soluble type or organic solvent-soluble type with conductivity. Specific examples thereof include polythienylalkanesulfonic acid derivative, complex, TCNQ, polyaniline derivative and the like.

In addition, in the present invention, it is preferable that the conducting film is water-soluble. Due to water-solubility of the conductive film, it becomes possible to easily remove with water from a resist, in the conductive film removing process described later, treatment is simple, and there is no influence on a chemical amplification-type resist, being advantageous from a viewpoint of the cost and the manufacturing efficiency. Specific examples of the conductive film include polythienylalkanesulfoni acid derivative, polyaniline derivative and the like.

Manufacturing of this conductive film layer can be performed by a spin coating method or a vacuum deposition method, or the like, being not limiting.

Next, a chemical amplification-type resist layer used in the present invention will be explained. A chemical amplification-type resist layer used in the present invention may be either of positive type or negative type as far as it is a material generally called a chemical amplification-type resist. The chemical amplification-type resist layer is not particularly limited as far as it is composed of a base resin, an acid generator and a dissolution suppressing agent in the case of a positive type, and it is composed of a base resin, an acid generator and a cross-linking agent in the case of a negative type.

A chemical amplification-type resist is a resist such that an acid is generated from an acid generator by irradiation with an electron beam, and the acid can promote a reaction of a photoresist such as cross-linking, cleavage and degradation as a catalyst by heating at a post-exposure baking process after irradiation with an electron beam. In addition, due to a catalytic reaction, that resist is highly sensitive to an electron beam.

Examples of a material which can be specifically used include OEBR_CAP209 (manufactured by Tokyo Ohka Kogyo Co., Ltd.), NEB22 (manufactured by Sumitomo Chemical Co., Ltd.) and the like.

In addition, in the present invention, a method for forming a film of the chemical amplification-type resist layer is not particularly limited, but an example thereof is a spin coating method.

Furthermore, any base can be used in the present invention as long as it is a material which can form a resist on a base such as glass and film, or the like, being not limiting. Specifically, silicon oxide and aluminium oxide, or the like are suitably used.

In addition, in the present invention, an apparatus for irradiating an electron beam and a pattern to be formed are not particularly limited. Here, a pattern used in the present invention may be a pattern to be drawn twice, such as a phase shift mask and the like. In the phase shift mask, since a base which is an insulating layer upon second drawing is directly on a drawing surface, by providing a conductive film on the surface, it becomes possible to ground when drawing with an electron beam.

### B. Conductive film removing process

The conductive film removing process in the present invention is a process of removing the above-mentioned conductive film from the substrate which is irradiated with an electron beam.

According to the present invention, by removing the above-mentioned conductive film before post-exposure baking described later, it becomes possible to prevent the above-mentioned conductive film which is acidic from acting as with an acid in the above-mentioned chemical amplification-type resist at post exposure-baking, and suppression of forming of a desired high precision pattern can be prevented.

Examples of this conductive film removing method include a dipping method, a spray method, a paddling method and the like, being not limited. Specifically, methods such as, peeling of the conductive polymer film is performed with pure water, a surfactant or an alcohol, and drying is performed by spin rotation.

### C. Post-exposure baking process

A post-exposure baking process in the present invention is a process of making an acid in the above-mentioned chemical amplification-type resist, generated in an electron beam-irradiated section at the above-mentioned irradiating process, act as a catalyst by heating a substrate after exposure. In this process, since an acid, generated in irradiated parts of the above-mentioned chemical amplification-type resist by heating the substrate, acts as a catalyst promoting cleavage or degradation of the resist in the case of a positive type, the resist at the electron-beam irradiated sections become soluble in a developer at a developing process described later. In addition, in the case of a negative type, since a generated acid acts as a catalyst promoting cross-linking of the resist, the resist at the electron-beam irradiated sections become insoluble in a developer described later.

In the present invention, a heating method in a post-exposure baking process can be a hot plate method, or the like, being not limiting.

### D. Developing process

A developing process in the present invention is a process of contacting a developer with a substrate after the above-mentioned post-exposure baking, and thereafter rinsing to form insoluble parts of a chemical amplification-type resist as a pattern.

In the present invention, an alkali system developer can be employed as a developer.

Examples of this developing method include a dipping method, a spraying method, a paddling method and the like, being not limiting.

### E. Others

In the present invention, the manufacturing method may comprise a pre-baking process, an etching process, a post-baking process and the like besides above-mentioned processes.

In addition, examples of a substrate to which a method for manufacturing a resist pattern of the present invention is applied include such a substrate on which a conductive film such as a metal film and the like is formed on a base, and a resist is formed on the metal film. In this case, since it becomes possible to ground from the conductive film on the surface by forming the conductive film on the above-mentioned resist at irradiation with an electron beam, adjustment and examination when grounding become easy, being advantageous from a viewpoint of the manufacturing efficiency and the like. In addition, since the conductive film is removed before post-exposure baking, it becomes possible to form a high precision pattern.

Further, the present invention is useful also for a pattern for which the entire substrate can not be grounded from the conductive film, such as a phase shift mask and the like. By forming the conductive film on the surface at irradiation with an electron beam, it becomes possible to ground the entire substrate and, since the conductive film is removed before post-exposure baking, it becomes possible to form a high precision pattern.

### 2. Photomask

A photomask in the present invention is such that it is manufactured by the above-mentioned method for manufacturing a resist pattern.

In the present invention, by manufacturing a photomask by the above-mentioned method for manufacturing a resist pattern, as described above, since the conductive film is removed before post-exposure baking, it is possible to prevent the conductive film from working as with a catalytic reaction by an acid in a chemical amplification-type resist. Therefore, it becomes possible to obtain a photomask having a fine pattern.

The present invention is not limited by the above-mentioned embodiments. The above-mentioned embodiments are examples, and any that has the substantially same essential features as the technical ideas described in claims of the present invention and exerts the same effects and advantageous is included in the technical scope of the present invention.

### Examples

The present invention will be explained more specifically by way of Example and Comparative Example below

### (Example)

A solution of the OEBR_CAP209 resist manufacture by Tokyo Ohka Kogyo Co., Ltd. which is a chemical amplification-type positive type resist was spin-coated on a photomask substrate to obtain a uniform resist film having a thickness of 400nm. The aquaSAVE (conductive polymer film) manufactured by Mitsubishi Rayon Co., Ltd. was spin-coated thereon to obtain a uniform film having a thickness of 20nm. Thereafter, pre-baking was performed at 130°C for 20 minutes. Here, since irradiation with an electron beam was not performed yet, there is little influence of the conductive polymer film on the resist.

This was exposed with a pattern using a 50keV electron beam exposing apparatus at an irradiation dose of 10uC/cm². After exposure, the conductive polymer film was peeled off by rinsing with pure water. Then, post-exposure baking was performed at 120°C for 15 minutes. Then, development was performed with a TMAH2.38% alkaline aqueous solution for 2 minutes, followed by rinsing with pure water to obtain a resist pattern.

A cross-sectional shape of the resulting resist pattern was observed with a scanning electron microscope, and a perpendicular resist pattern shape was obtained.

### (Comparative Example)

In a resist pattern which peeling of the conductive polymer film after exposure mentioned in the above Example was performed at a developing process, not before post-exposure baking, corners of the upper part of the resist were round, and the amount of a lost film became greater.

## Claims

1. A method for manufacturing a resist pattern comprising:
an irradiating process of irradiating a substrate having a chemical amplification-type resist layer on one surface of a base, and a conductive film which is formed on the chemical amplification-type resist layer and releases an acid by heating, with an electron beam in a pattern manner from the conductive film side,
a conductive film removing process of removing the conductive film from the substrate which is irradiated with an electron beam,
a post-exposure baking process of subjecting the substrate, from which the conductive film is removed, to post-exposure baking, and
a developing process of performing development on the substrate which is subjected to post-exposure baking, to form a pattern comprising the chemical amplification-type resist.

2. A method for manufacturing a resist pattern according to claim 1, wherein the conductive film comprises a polymer.

3. A method for manufacturing a resist pattern according to claim 2 wherein the conductive polymer is water-soluble or organic solvent-soluble.

4. A method for manufacturing a resist pattern according to any one of the preceding claims, wherein the conductive film is water soluble.

5. A method for manufacturing a resist pattern according to any one of the preceding claims in which the chemical amplification-type resist layer comprises a base resin and an acid generator and either a dissolution suppressing agent or a cross linking agent.

6. A method for manufacturing a resist pattern according to any one of the preceding claims wherein the developing process comprises contacting a developer with the substrate and rinsing the substrate to form insoluble parts of a chemical amplification-type resist layer as a pattern.

7. A method for manufacturing a resist pattern according to any one of the preceding claims wherein the conducting film is water soluble and the conductive film removing process comprises contacting the conductive film with water so as to remove the conductive film.

8. A photomask, obtainable by a method for manufacturing a resist pattern according to any one of claims 1 to 7.
